(19) Europäisches Patentamt
European Patent Office
Office européen des brevets

(11) **EP 4 586 025 A1**

(12) # EUROPEAN PATENT APPLICATION

(43) Date of publication:
**16.07.2025 Bulletin 2025/29**

(21) Application number: **24199118.1**

(22) Date of filing: **09.09.2024**

(51) International Patent Classification (IPC):
**G04F 5/00** (2006.01)    **G04F 5/14** (2006.01)
**G04G 5/00** (2013.01)    **H04J 3/06** (2006.01)

(52) Cooperative Patent Classification (CPC):
**H04J 3/06; G04G 5/00; G04F 5/14**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.09.2023 CN 202311154907**

(71) Applicant: **Bao Jie Electronics (Shenzhen)
Limited
Shenzhen Guangdong 518000 (CN)**

(72) Inventor: **GUAN, Muquan
Shenzhen, 518000 (CN)**

(74) Representative: **Metida
Gyneju str. 16
01109 Vilnius (LT)**

(54) **CONTROL APPARATUS AND METHOD FOR TIMING APPARATUS**

(57)    A control apparatus and method for a timing apparatus, The present invention pertains to the field of time-sequence control technologies of electronic devices. The timing device uses a control device, the apparatus includes a Pierce oscillation network module composed of quartz crystal oscillators, a digital signal conversion module, a time setting control module, a detection controlling module, an adjustment controlling module, and an output module, The present invention can greatly improve the accuracy of time sequence control and the accuracy of the output from the Pierce oscillation network module composed of quartz crystal oscillators.

**EP 4 586 025 A1**

## Description

## Technical Field

The present invention pertains to the field of time-sequence control technologies of electronic devices, specifically to a control apparatus and method for a timing apparatus.

## Background Information

Different time sequences are present between different execution operations of an electronic device. Typically, a timing controller generates multiple time-sequence control signals based on a local time signal, and the generated multiple time-sequence control signals are used to respectively control different modules to perform response functional operations. With the technological development, the control logic of the electronic device tends to become more complex and faster. This imposes higher requirements on the number, clock accuracy, and the like of the generated time-sequence control signals. Local clock signals are typically generated using crystal oscillators, and issues related to manufacturing process, material, and the like cause inevitable frequency deviations. Moreover, the cheaper the crystal oscillator, the greater the frequency deviation of the generated local clock signal, which leads to more serious interference in time sequence control.

## BRIEF SUMMARY

The invention aims to provide a control apparatus and method for a timing apparatus with simple structure and reasonable design in order to solve the above problems.

The invention realizes the above purpose through the following technical scheme.

The first part of the invention provides a control method for a timing apparatus. This method includes the following steps.

Obtain first time data output by a Pierce oscillation network; and based on the first time data, obtain first time-sequence control data.

Based on the first time-sequence control data and actual time-sequence control data, obtain error data of the first time-sequence control data, where the first time-sequence control data includes several sets of time-sequence control signals, and the actual time-sequence control data includes actual time-sequence control signals corresponding to the several sets of time-sequence control signals.

Based on the error data, obtain frequency timing data; and based on the frequency timing data, after a set duration, obtain second time-sequence control data.

Based on the second time-sequence control data and the actual time-sequence control data, obtain error data of the second time-sequence control data, Based on the error data of the second time-sequence control data, obtain a result of control completion, regeneration, or alarm.

As a further optimization scheme of the invention, as the error data is determined, when the difference between the time data in a single time-sequence control signal and the time data in the actual time-sequence control signal is greater than a set value, the time-sequence control signal is determined as an error signal.

As a further optimization scheme of the invention, it is determined whether all the time-sequence control signals are error signals based on the reference value $\overline{X}^*$ of the time data in all the time-sequence control

$$\overline{X}^* = \frac{\sum_{i=1}^{n} \dfrac{X_i}{\sigma_i^2}}{\sum_{i=1}^{n} \dfrac{1}{\sigma_i^2}}$$

signals, where , where $X_i$ represents base time sequence data in each time-sequence control signal, the base time sequence data is the base time value in the time data of the time-sequence control signal, and $\sigma_i$ represents a variance of the time data in each time-sequence control signal.

As a further optimization scheme of the invention, when the time-sequence control signal is an error signal, the reference time data is obtained and synchronized, frequency timing data is obtained, and counting is performed. During the corrected timing duration, the reference time is obtained, and based on the reference time, time deviation data and deviation direction data are obtained. The first time data is adjusted based on the deviation direction data to obtain the first time-sequence control data, and based on the first time-sequence control data, the second time-sequence control data is obtained.

As a further optimization scheme of the invention, Based on the deviation direction data, the time error rate is obtained, the second error duration is obtained, and the adjustment data is obtained.

As a further optimization scheme of the invention, based on the oscillation frequency timing in the Pierce oscillation network, the reference time is obtained during the corrected timing duration.

As a further optimization scheme of the invention, based on the frequency counter, the standard output frequency signal of the frequency counter is obtained and counted. After the timing duration is corrected, the reception of the frequency signal is stopped, the cumulative frequency count value is obtained, and the reference time is obtained.

The second aspect of the invention provides a control apparatus for a timing apparatus. The apparatus includes a Pierce oscillation network module composed of quartz crystal oscillators, a digital signal conversion module, a time setting control module, a detection controlling module, an adjustment controlling module, and an output module. The Pierce oscillation network module is configured to generate a local clock signal, that is, time data;The time setting control module is configured to generate time sequence control data based on the time data;The detection controlling module is configured to collect the time sequence control data generated by the time setting control module and actual time-sequence control data executed;The adjustment controlling module is configured to adjust the time data output by the Pierce oscillation network module;The digital signal conversion module is configured to coordinate the input and output conversion of digital signals of the various modules;The output module is configured to output a corresponding result in a preset form based on a secondary detection result from the detection controlling module after the adjustment by the adjustment controlling module.

The beneficial effects of the utility model are as follows: In the present invention, actual time-sequence control data is compared with first time-sequence data generated by an apparatus to obtain corresponding error data. The error data is analyzed to adjust first time data, thus improving the accuracy of the output from the Pierce oscillation network. Then, the generated second time-sequence control data is verified correspondingly. If an error disappears, a control completion result is output; if the error is reduced, a re-production result is output. The second time-sequence control data is then used as the first time-sequence control data in the previous step, and the steps are re-executed for a set number of times. If the error still cannot be eliminated, an alarm result is output; if the error cannot be reduced in a single instance, the alarm result is directly output. The present invention can greatly improve the accuracy of time sequence control and the accuracy of the output from the Pierce oscillation network module composed of quartz crystal oscillators.

BRIEF DESCRIPTION OF THE DRAWINGS

FIG. 1 is a flowchart of a control method for a timing apparatus according to the present invention.
FIG. 2 is a flowchart of an adjustment method for time data in the control method for a timing apparatus according to the present invention.
FIG. 3 is a flowchart of another adjustment method for the time data in the control method for a timing apparatus according to the present invention.
FIG. 4 is a module system diagram of a control apparatus for a timing apparatus according to the present invention.

DETAILED DESCRIPTION OF THE DRAWINGS AND THE PRESENTLY PREFERRED EMBODIMENTS

The following is a further detailed description of this application in combination with the attached drawings. It is necessary to point out here that the following specific implementation mode is only for further explanation of this application and cannot be understood as a limitation of the scope of protection of this application. Technicians in this field can make some non-essential improvements and adjustments to this application according to the above application content.

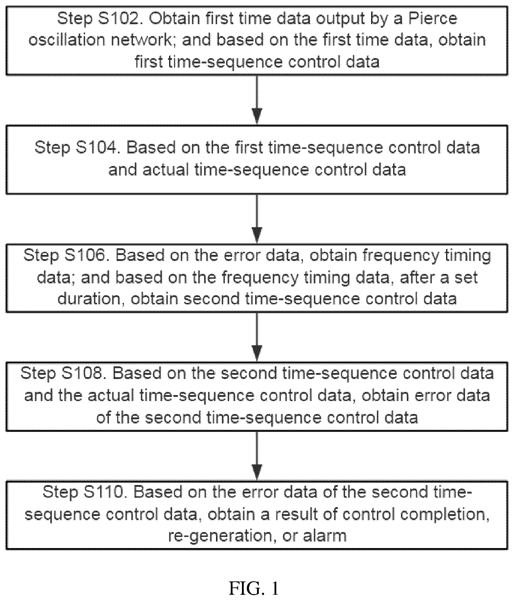

Refer to FIG. 1, which is a flowchart of a control method for a timing apparatus. This method includes the following steps.

Step S102. Obtain first time data output by a Pierce oscillation network; and based on the first time data, obtain first time-sequence control data.

Step S104. Based on the first time-sequence control data and actual time-sequence control data, obtain error data of the first time-sequence control data, where the first time-sequence control data includes several sets of time-sequence control signals, and the actual time-sequence control data includes actual time-sequence control signals corresponding to the several sets of time-sequence control signals.

Step S106. Based on the error data, obtain frequency timing data; and based on the frequency timing data, after a set duration, obtain second time-sequence control data.

Step S108. Based on the second time-sequence control data and the actual time-sequence control data, obtain error data of the second time-sequence control data.

Step S110. Based on the error data of the second time-sequence control data, obtain a result of control completion, re-generation, or alarm.

In this embodiment, the actual time-sequence control data is compared with the first time-sequence data generated by the apparatus to obtain the corresponding error data. The error data is analyzed to adjust the first time data, thus improving the accuracy of the output from the Pierce oscillation network. Then, the generated second time-sequence control data is verified correspondingly. If an error disappears, the control completion result is output; if the error is reduced, the re-production result is output. The second time-sequence control data is then used as the first time-sequence control data in the previous step, and the steps are re-executed for a set number of times. If the error still cannot be eliminated, the alarm result is output; if the error cannot be reduced in a single instance, the alarm result is directly output.

When the error data is determined correspondingly, the error of the time data in a single time-sequence control signal and the mutual differences between the time data in a single time-sequence control signal and the time data in all time-sequence control signals are considered.

Further, as the error data is determined, when the difference between the time data in a single time-sequence control signal and the time data in the actual time-sequence control signal is greater than a set value, the time-sequence control signal is determined as an error signal.

Furthermore, as the error data is determined, it is determined whether all the time-sequence control signals are error signals based on the reference value $\overline{X}^*$ of the time data in all the time-sequence control

$$\overline{X}^* = \frac{\sum_{i=1}^{n} \dfrac{X_i}{\sigma_i^2}}{\sum_{i=1}^{n} \dfrac{1}{\sigma_i^2}}$$

signals,where , where $X_i$ represents base time sequence data in each time-sequence control signal, the base time sequence data is the base time value in the time data of the time-sequence control signal, and $\sigma_i$ represents a variance of the time data in each time-sequence control signal.Similarly, based on the difference between the time data in a single time-sequence control signal and the reference value, it is determined whether the time data of the time-sequence control signal is an error value.

Further, when the time-sequence control signal is an error signal, the reference time data is obtained and synchronized, frequency timing data is obtained, and counting is performed. During the corrected timing duration, the reference time is obtained, and based on the reference time, time deviation data and deviation direction data are obtained. The first time data is adjusted based on the deviation direction data to obtain the first time-sequence control data, and based on the first time-sequence control data, the second time-sequence control data is obtained.Based on the deviation direction data, the time error rate is obtained, the second error duration is obtained, and the adjustment data is obtained.

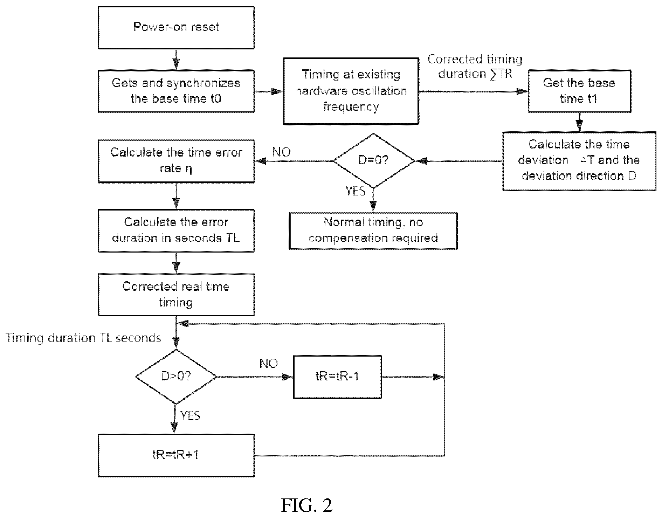

Specifically, there are two cases, as shown in FIG. 2 (it should be added that $T_c$ is the oscillation frequency timing duration). One case is that based on the oscillation frequency timing in the Pierce oscillation network, the reference time is obtained during the corrected timing duration.

Specifically, the existing Pierce oscillation network module is maintained, and referring to the existing precise timing apparatus, the precise external reference time read twice is input for comparison with the reference time in the Pierce oscillation network module, thus obtaining the time deviation value. This deviation value is converted into a time compensation value to compensate for the timing of the Pierce oscillation network module in real time, thereby achieving relatively high timing accuracy. This method is relatively simple to implement and has low costs. However, to obtain a time compensation value with certain accuracy, the required correction time span is long.

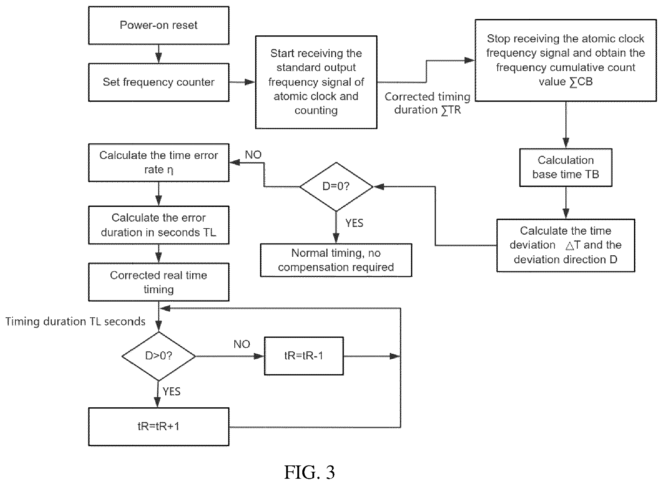

As shown in FIG. 3, the other case is that based on the frequency counter, the standard output frequency signal of the frequency counter is obtained and counted. After the timing duration is corrected, the reception of the frequency signal is stopped, the cumulative frequency count value is obtained, and the reference time is obtained.

Specifically, a stable and high-precision frequency signal is directly captured, which is typically at 5 MHz, 10M Hz, or the like and output by an atomic clock or another ultra-high precision oscillator. The reference time is calculated and then compared with the internal reference time of the Pierce oscillation network module to obtain the time compensation value, which is then used to make real-time correction to the watch time.

This method requires configuring an atomic clock or another ultra-high precision oscillator during the development and production phase (this is the configuration method for the apparatus before it leaves the factory, and does not fundamentally change the structure or cost of the Pierce oscillation network module). However, because the correction is based on the frequency signal, the correction time to obtain the compensation value is greatly shortened, generally taking only 1 to 3 minutes.

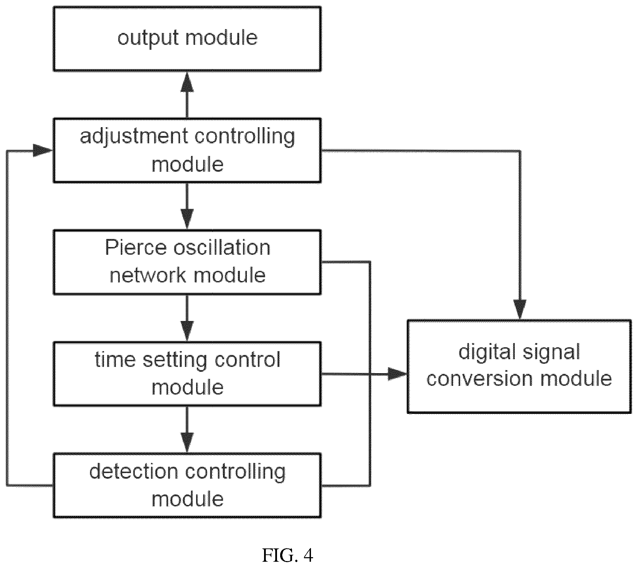

As shown in FIG. 4, in this embodiment, the present invention also provides a control apparatus for a timing apparatus. The apparatus includes a Pierce oscillation network module composed of quartz crystal oscillators, a digital signal conversion module, a time setting control module, a detection controlling module, an adjustment controlling module, and an output module.The Pierce oscillation network module is configured to generate a local clock signal, that is, time data.The time setting control module is configured to generate time sequence control data based on the time data.The detection controlling module is configured to collect the time sequence control data generated by the time setting control module and actual time-sequence control data executed.The adjustment controlling module is configured to adjust the time data output by the Pierce oscillation network module.The digital signal conversion module is configured to coordinate the input and output conversion of digital signals of the various modules.The output module is configured to output a corresponding result in a preset form based on a secondary detection result from the detection controlling module after the adjustment by the adjustment controlling module.

In the several embodiments provided in this application, it should be understood that the devices and methods disclosed may be implemented by other means. The device embodiments described above are only schematic, for example, the division of the unit is only a logical function of the division, the actual implementation can have another division, such as: multiple units or components can be combined, or can be integrated into another system, or some features can be ignored, or not executed. In addition, the coupling, direct coupling, or communication connection between the components shown or discussed may be through interfaces, indirect coupling or communication connections of devices or units, which may be electrical, mechanical, or other forms.

The unit described above as a separate part may or may not be physically separate, and the part shown as a unit may or may not be a physical unit; It can be located in one place or distributed to multiple network units. Some or all of the units can be selected according to the actual needs to realize the purpose of this embodiment scheme.

In addition, all functional units in each embodiment of the invention can be integrated in a processing unit, or each unit can be separately as a unit, or two or more units can be integrated in a unit; The integrated unit can be realized either in the form of hardware or in the form of hardware and software functional units.

It may be understood by persons of ordinary skill in the art that all or part of the steps to implement the embodiments of the method may be completed by hardware related to the program instruction, the said program may be stored in a computer readable storage medium, and the program, when executed, performs the steps including the embodiments of the method; The aforementioned storage media include: mobile storage devices, read-only Memory (ROM, Read Only Memory), Random Access memory (RAM, Random Access Memory), disks or discs and other media that can store program code.

## Claims

1. A control method for a timing apparatus, wherein this method includes the following steps,

   Obtain first time data output by a Pierce oscillation network; and based on the first time data, obtain first time-sequence control data;
   Based on the first time-sequence control data and actual time-sequence control data, obtain error data of the first time-sequence control data, where the first time-sequence control data includes several sets of time-sequence control signals, and the actual time-sequence control data includes actual time-sequence control signals corresponding to the several sets of time-sequence control signals;
   Based on the error data, obtain frequency timing data; and based on the frequency timing data, after a set duration, obtain second time-sequence control data;
   Based on the second time-sequence control data and the actual time-sequence control data, obtain error data of the second time-sequence control data; Based on the error data of the second time-sequence control data, obtain a result of control completion, re-generation, or alarm; as the error data is determined, when the difference between the time data in a single time-sequence control signal and the time data in the actual time-sequence control signal is greater than a set value, the time-sequence control signal is determined as an error signal; it is determined whether all the time-sequence control signals are error signals based on the reference value $\overline{X}^*$ of the time data in all the time-sequence

   $$\overline{X}^* = \frac{\sum\limits_{i=1}^{n} \frac{X_i}{\sigma_i^2}}{\sum\limits_{i=1}^{n} \frac{1}{\sigma_i^2}}$$

   control signals, where , where $X_i$ represents base time sequence data in each time-sequence control signal, the base time sequence data is the base time value in the time data of the time-sequence control signal, and $\sigma_i$ represents a variance of the time data in each time-sequence control signal;
   when the time-sequence control signal is an error signal, the reference time data is obtained and synchronized, frequency timing data is obtained, and counting is performed. During the corrected timing duration, the reference time is obtained, and based on the reference time, time deviation data and deviation direction data are obtained. The first time data is adjusted based on the deviation direction data to obtain the first time-sequence control data, and based on the first time-sequence control data, the second time-sequence control data is obtained;
   Based on the deviation direction data, the time error rate is obtained, the second error duration is obtained, and the adjustment data is obtained.

2. The control method for a timing apparatus according to claim 1, based on the oscillation frequency timing in the Pierce oscillation network, the reference time is obtained during the corrected timing duration.

3. The control method for a timing apparatus according to claim 1, based on the frequency counter, the standard output frequency signal of the frequency counter is obtained and counted. After the timing duration is corrected, the reception of the frequency signal is stopped, the cumulative frequency count value is obtained, and the reference time is obtained.

4. A control apparatus for a timing apparatus, wherein the apparatus includes a Pierce oscillation network module composed of quartz crystal oscillators, a digital signal conversion module, a time setting control module, a detection controlling module, an adjustment controlling module, and an output module;

   The Pierce oscillation network module is configured to generate a local clock signal, that is, time data;
   The time setting control module is configured to generate time sequence control data based on

**EP 4 586 025 A1**

the time data;

The detection controlling module is configured to collect the time sequence control data generated by the time setting control module and actual time-sequence control data executed;

The adjustment controlling module is configured to adjust the time data output by the Pierce oscillation network module;

The digital signal conversion module is configured to coordinate the input and output conversion of digital signals of the various modules;

The output module is configured to output a corresponding result in a preset form based on a secondary detection result from the detection controlling module after the adjustment by the adjustment controlling module.

Step S102. Obtain first time data output by a Pierce oscillation network; and based on the first time data, obtain first time-sequence control data

Step S104. Based on the first time-sequence control data and actual time-sequence control data

Step S106. Based on the error data, obtain frequency timing data; and based on the frequency timing data, after a set duration, obtain second time-sequence control data

Step S108. Based on the second time-sequence control data and the actual time-sequence control data, obtain error data of the second time-sequence control data

Step S110. Based on the error data of the second time-sequence control data, obtain a result of control completion, re-generation, or alarm

FIG. 1

FIG. 2

FIG. 3

FIG. 4

**Europäisches Patentamt**

**European Patent Office**

**Office européen des brevets**

# DECLARATION

which under Rule 63 of the European Patent Convention shall be considered, for the purposes of subsequent proceedings, as the European search report

**Application Number**

EP 24 19 9118

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|
| Reason: | INV.<br>G04F5/00<br>G04F5/14<br>G04G5/00<br>H04J3/06 |

The claims of the present application as a whole do not comply with the provisions of clarity in Article 84 EPC for claims 1 to 4 and sufficiency of disclosure in Art. 83 EPC, as it is particularly burdensome for a skilled person to establish the subject-matter for which protection is sought. Non-compliance with the substantive provisions is such that a meaningful search of the whole claimed subject-matter could not be carried out (Rule 63 EPC and EPC Guidelines B-VIII, 3).

Clarity Art. 84 EPC
The application does not meet the requirements of Article 84 EPC for claims 1 to 4 for the reasons set out in the separate sheet.

Lack of disclosure Art. 83 EPC
The present application does additionally not meet the requirements of Article 83 EPC. The application is considered to not disclose the invention in a manner sufficiently clear and complete for it to be carried out by a person skilled in the art.
The description does not provide more information that would enable the skilled person to put the invention into practice without undue experimentation. In fact the description and figures do not provide more clarity and in essence merely repeat what can be derived from the wording of the claims without serving as a good basis to clarify them.
However, an invention must concern a technical problem (Rule 42(1)(c) EPC) and

-/--

| Place of search | Date | Examiner |
|---|---|---|
| The Hague | 6 June 2025 | Wienema, David |

EPO FORM 1504 (P04F37)

Europäisches
Patentamt

European
Patent Office

Office européen
des brevets

## DECLARATION

**Application Number**

which under Rule 63 of the European Patent Convention shall be considered, for the purposes of subsequent proceedings, as the European search report

EP 24 19 9118

| | CLASSIFICATION OF THE APPLICATION (IPC) |
|---|---|
| The Search Division considers that the present application, does not comply with the provisions of the EPC to such an extent that it is not possible to carry out a meaningful search into the state of the art on the basis of all claims<br><br>Reason:<br><br>it must have technical features, which solve that technical problem.<br>The description is required to disclose the invention in such terms that the technical problem and its solution can be understood (Rule 42(1)(c) EPC).<br>Further, the application must reflect the actual contribution to the art and must enable the person skilled in the art to carry out the whole subject-matter which is defined in the claims without undue burden, i.e. it must enable the person skilled in the art to perform the invention over the whole range of the claim (cf. the Guidelines F-III 3.1 and T 659/93 , T 94/05).<br>However, the description does not reveal how the a control apparatus and method for a timing apparatus solving the frequency deviations problem due to manufacturing process, material, and the like with simple structure and reasonable design is achieved and hence does not enable the person skilled in the art to put the invention into practise, contrary to Article 83 EPC, because the technical features required to solve the problem are neither disclosed nor straightforward.<br>In the board's view, a purely formal support by the description, i.e. a verbatim repetition of the mention of a claimed feature, could not meet these requirements ( T 94/05 ; see also T 127/02 and T 1048/05 ).<br>The application does, hence, not disclose in a sufficiently clear manner how to solve the technical problem underlying the present application and does, therefore, not meet the requirements of Article 83<br><div align="center">-/--</div> | |

| Place of search | Date | Examiner |
|---|---|---|
| The Hague | 6 June 2025 | Wienema, David |

EPO FORM 1504 (P04F37)

Europäisches
Patentamt

European
Patent Office

Office européen
des brevets

# DECLARATION

**Application Number**

which under Rule 63 of the European Patent Convention shall be considered, for the purposes of subsequent proceedings, as the European search report

EP 24 19 9118

| The Search Division considers that the present application, does not comply with the provisions of the EPC to such an extent that it is not possible to carry out a meaningful search into the state of the art on the basis of all claims | **CLASSIFICATION OF THE APPLICATION (IPC)** |
|---|---|

Reason:

EPC.

The applicant's attention is drawn to the fact that a search may be carried out during examination following a declaration of no search under Rule 63 EPC, should the problems which led to the declaration being issued be overcome (see EPC Guideline C-IV, 7.3).

| Place of search | Date | Examiner |
|---|---|---|
| The Hague | 6 June 2025 | Wienema, David |

EPO FORM 1504 (P04F37)

page 3 of 3